# EUROPÄISCHE PATENTSCHRIFT

(11) **EP 1 138 653 B1**
(45) Veröffentlichungstag und Bekanntmachung des Hinweises auf die Patenterteilung: **15.01.2003**
(21) Anmeldenummer: 01106426.8
(22) Anmeldetag: 22.03.2001
(51) Int. Cl.: C04B 35/58, C04B 35/583, C23C 14/24

(54) **Material für alterungsbeständige keramische Verdampfer**
Material for non-aging ceramic evaporators
Materiau pour évaporateurs ceramiques resistant à vieillissement

(30) Priorität: 30.03.2000 DE 10015850
(43) Veröffentlichungstag der Anmeldung: 04.10.2001
(73) Patentinhaber: Wacker-Chemie GmbH, 81737 München (DE)
(72) Erfinder: Jüngling, Thomas, Dr., 87437 Kempten (DE)
(74) Vertreter: Potten, Holger

(56) Entgegenhaltungen:
- GB-A- 2 132 227
- US-A- 3 544 486

## Beschreibung

Die Erfindung betrifft ein Material für alterungsbeständige keramische Verdampfer.

Das gebräuchlichste Verfahren zum Beschichten von flexiblen Substraten mit Metallen, insbesondere mit Aluminium, ist die sog. Hochvakuum-Bandbedampfung. In einer Metallisierungsanlage wird das zu beschichtende Substrat über eine gekühlte Walze geführt und dabei dem Aluminiumdampf ausgesetzt, der sich auf der Substratoberfläche als dünne Metallschicht niederschlägt.

Zur Erzeugung des erforderlichen konstanten Dampfstromes werden keramische Verdampfer im direkten Stromdurchgang auf etwa 1450°C erhitzt. Aluminiumdraht wird kontinuierlich zugeführt, auf der Keramikoberfläche verflüssigt und bei einem Vakuum von ca. 10⁻⁴ mbar verdampft.

In Metallisierungsanlagen sind eine Reihe von Verdampfern so angeordnet, daß sich über die gesamte Breite des Bandes eine gleichmäßig dicke Aluminiumschicht niederschlägt. Die Halterung der Verdampfer erfolgt durch gekühlte Kupferspannbacken, wobei sowohl die sog. stirnseitige als auch die sog. seitliche Einspannung möglich ist.

Die Breite und Länge des Verdampfers werden entsprechend der erforderlichen Abdampfrate (g Al min⁻¹) gewählt. Der übliche Querschnitt von Verdampfern ist rechteckig. Neben Verdampfern mit rechteckigem Querschnitt sind auch eine Reihe weiterer Querschnitte bekannt. Einzelheiten dazu finden sich beispielsweise in US-A- 4,089,643 oder DE 19823908 (entspricht der US Anmeldung mit der Serial Number 09/315320).

Ausgehend von der Geometrie des Verdampfers und den elektrischen Eigenschaften des Keramikmaterials (charakterisiert durch den spezifischen Widerstand R_{spec}) läßt sich der Ohm'sche Widerstand R des Verdampfers im elektrischen Stromkreis nach Gleichung (1) berechnen.

R = R_{spec} x L/A L: Länge des Verdampfers
A: leitfähiger Querschnitt

Der Verdampfer verhält sich im Stromkreis wie ein metallischer Widerstand, d.h. sein Widerstand nimmt mit steigender Temperatur zu. Für die genaue Charakterisierung der elektrischen Eigenschaften ist daher zusätzlich die Kenntnis des Verhältnisses zwischen Widerstand bei Betriebstemperatur (R_{HT}) und Raumtemperatur (R_{RT}) notwendig. Für keramische Verdampfer liegt das Verhältnis R_{HT}/R_{RT} zwischen 2,3 - 6,0.

Man unterscheidet je nach Anzahl der Hauptkomponenten in der Zusammensetzung der Verdampfer zwischen 2-Komponentenverdampfern (bestehend überwiegend aus TiB₂ als leitender Phase und BN als Isolator) und 3-Komponentenverdampfern (bestehend überwiegend aus TiB₂ als leitender Phase und einem Gemisch aus BN und AlN als Isolator). Im 3-Komponentenverdampfer ersetzt AlN aus wirtschaftlichen Gründen einen Teil des BN, da AlN erheblich preisgünstiger ist (siehe US-A-3544486). Im Regelfall enthält der 3-Komponenten-Verdampfer daher 15 - 20% AlN. Solche Zusammensetzungen sind u.a. in Patenten (z.B. US-A-3,915,900 Spalte 1, Zeilen 10 und 11 bzw. US-A-4,089,643 Spalte 2, Zeile 5) beschrieben.

Da 2-Komponentenverdampfermaterialien eine geringere Hochtemperatur-Biegefestigkeit aufweisen als 3-Komponentenverdampfermaterialien, enthalten sie in der Regel noch 0,1 - 5 Gew.% CaO, (siehe GB-A-2 132 227).

2-Komponentenverdampfer werden in der Regel nach der Fertigung in Beutel aus metallisierter Folie verpackt, um die Verdampfer vor Feuchtigkeitsaufnahme während des Transportes oder der Lagerung bis zum Einsatz zu schützen. Es hat sich nämlich gezeigt, daß 2-Komponentenverdampfermaterial durch die Aufnahme von Feuchtigkeit in charakteristischer Weise geschädigt wird. Die Schädigung wird während der Aufheizung des Verdampfers, die in Metallisierungsanlagen im direkten Stromdurchfluß erfolgt, durch einen stark ansteigenden Widerstand erkennbar. In der Praxis bedeutet dies, daß ein Verdampfer aus dem geschädigten Material in Metallisierungsanlagen nicht aufgeheizt werden kann, da es für die gängigen Leistungsversorgungen (10 - 15 Volt sekundärseitig) zu hochohmig ist.

Trotz dieses Nachteils werden 2-Komponentenverdampfer häufig eingesetzt, da sie bei höheren Temperaturen betrieben werden können und damit bis ca. +50% höhere Abdampfraten erreichen als 3-Komponentenverdampfer. Zudem besitzen sie eine höhere Lebensdauer als 3-Komponentenverdampfer.

Die Erfindung hat die Aufgabe ein keramisches Material zur Verfügung zu stellen, das sich zur Herstellung von 2-Komponentenverdampfer eignet, das widerstandsfähiger gegen Luftfeuchtigkeit und damit alterungsbeständiger ist, als bekannte Materialien für 2-Komponentenverdampfer.

Die Aufgabe wird gelöst durch ein keramisches Material enthaltend 45 bis 55 Gew.% TiB₂ und 40,5 bis 54,7 Gew.% BN und 0,1 - 1,5 Gew.% Ca in Form einer Verbindung ausgewählt aus der Gruppe der Calciumoxide, der Calciumborate und ihrer Gemische, dadurch gekennzeichnet, daß es 0,2 bis 3 Gew.% einer Verbindung ausgewählt aus der Gruppe der Oxide, Carbide und Nitride der Elemente Al, Si, Zr, Ti und ihrer Gemische enthält.

Vorzugsweise enthält das keramische Material 0,2 bis 1,5 Gew.% einer Verbindung ausgewählt aus der Gruppe der Oxide, Carbide und Nitride der Elemente Al, Si, Zr, Ti und ihrer Gemische.

Besonders bevorzugt enthält das keramische Material 0,2 bis 0,5 Gew.% einer Verbindung ausgewählt aus der Gruppe der Oxide, Carbide und Nitride der Elemente Al, Si, Zr, Ti und ihrer Gemische.

Vorzugsweise handelt es sich bei der Verbindung ausgewählt aus der Gruppe der Oxide, Carbide und Nitride der Elemente Al, Si, Zr, Ti und ihrer Gemische um eine Verbindung ausgewählt aus der Gruppe der Nitride der Elemente Al, Si, Zr, Ti und ihrer Gemische.

Besonders bevorzugt handelt es sich bei der Verbindung ausgewählt aus der Gruppe der Oxide, Carbide und Nitride der Elemente Al, Si, Zr, Ti und ihrer Gemische um AlN.

Insbesondere bevorzugt besteht das erfindungsgemäße Material aus den genannten Komponenten.

Das erfindungsgemäße Verdampfermaterial unterscheidet sich hinsichtlich seiner anwendungsrelevanten Eigenschaften (Benetzung mit flüssigem Aluminium, Abdampfrate bei Betriebstemperatur, Lebensdauer) nicht von herkömmlichem 2-Komponentenverdampfermaterial, es zeigt jedoch keine zeitabhängige Veränderung der Materialeigenschaften. Insbesondere der spezifische Widerstand verändert sich nicht in der für 2-Komponentenverdampfermaterial bekannten Weise.

Das erfindungsgemäße Material läßt sich herstellen, wie für übliche 2-Komponentenverdampfermaterialien bekannt. Die Herstellung kann beispielsweise durch Heißpressen homogener Pulvergemische in Graphitformen unter Anwendung von Stempeldruck erfolgen, wobei Temperaturen von mindestens 1800°C erforderlich sind, um feste Körper mit ausreichender Dichte zu erzielen (US 4,528,120 Spalte 1, Zeile 36-47).

In eine übliche TiB₂/BN/CaO-Mischung werden die Verbindungen ausgewählt aus der Gruppe der Oxide, Carbide und Nitride der Elemente Al, Si, Zr Ti und ihrer Gemische in feinverteilter Form eingebracht. Dies erfolgt vorzugsweise bereits während des Mischens der erstgenannten Komponenten.

TiB₂ und BN werden vorzugsweise in Form feiner Pulver, wie im Stand der Technik (beispielsweise US 4,528,120 Spalte 5 Tabelle oberhalb Example 1) bekannt eingesetzt.

Die Verbindungen ausgewählt aus der Gruppe der Oxide, Carbide und Nitride der Elemente Al, Si, Zr, Ti und ihrer Gemische werden vorzugsweise als Pulver einer mittleren Teilchengröße von 5 bis 15 µm, vorzugsweise von 8 bis 12 µm, eingesetzt.

Solche Pulver sind beispielsweise unter der Bezeichnung SiC Grade UF-10, TiC High Vacuum 250, ZrC Grade A, AlN Grade A und Grade B, Si₃N₄ Grade B7 bei der Firma H.C. Starck (Goslar) käuflich erhältlich. Sie lassen sich auch in an sich bekannter Art und Weise aus käuflichen Pulvern herstellen. So läßt sich beispielsweise das besonders bevorzugt verwendete AlN auch durch Nitridierung von Aluminiumpulvern und anschließende Mahlung z.B. in Kugelmühlen herstellen.

Das erfindungsgemäße Material ist insbesondere zur Herstellung von Verdampfern die zur Beschichtung von flexiblen Substraten mit Metallen eingesetzt werden, geeignet. Die Herstellung der Verdampfer aus einem Block des erfindungsgemäßen Materials erfolgt wie im Stand der Technik bekannt. Dies kann beispielsweise durch Aussägen der erwünschten Form erfolgen.

Die Erfindung betrifft somit auch Verdampfer, die dadurch gekennzeichnet sind, daß sie aus dem erfindungsgemäßen keramischen Material bestehen.

Das folgende Beispiel dient der weiteren Erläuterung der Erfindung:

### Beispiele

### Beispiel 1

Herstellung und Vergleich der Alterungsbeständigkeit eines erfindungsgemäßen Verdampfers (EV) und eines 2-Komponentenvergleichsverdampfers (2K-VV) gemäß dem Stand der Technik

Es wurden homogene Pulvermischungen folgender Zusammensetzungen hergestellt:
2K-VV: 48% TiB₂, 51% BN, 1% CaO
EV: 48% TiB₂, 49,5% BN, 1% CaO, 1,5% AlN

Diese homogenen Pulvermischungen wurden jeweils durch axiales zweiseitiges Heißpressen in Graphitmatrizen bei Temperaturen > 1800°C und einem Druck > 25 MPa zu Sinterkörpern mit einer Dichte > 95% der theoretischen Dichte verdichtet. Aus den heißgepreßten Sinterkörpern wurden mittels Bandsägen je 2 Verdampfer herausgearbeitet.

Die Verdampfer hatten eine rechteckige Form sowie eine für Testzwecke übliche Verdampfergeometrie von 10 x 20 x 120 mm.

Je 1 erfindungsgemäßer und ein üblicher Verdampfer wurden durch lineare Steigerung der Leistung auf einen Wert von 4 kW erhitzt. Diese Leistung ist notwendig, um bei der gewählten Verdampfergeometrie und Materialzusammensetzung die für Verdampfer typische Arbeitstemperatur zu erreichen.

Die beiden anderen Verdampfer wurden zunächst 12 Stunden in einem Exsikkator unter 100% Luftfeuchtigkeit gelagert, ehe sie wie vorstehend beschrieben erhitzt wurden.

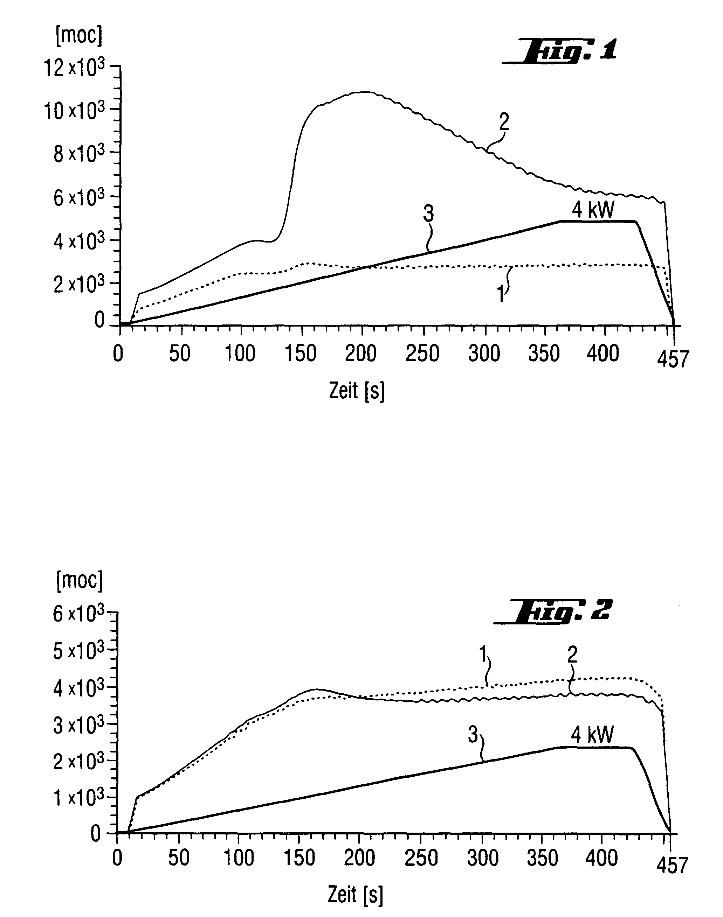

Die Ergebnisse sind in den Figuren 1 und 2 dargestellt. Dargestellt ist der Widerstandsverlauf in Abhängigkeit von der Zeit bei linearer Steigerung der Leistung auf einen Wert von 4 kW (Kurve 3 in Fig. 1 und 2).

Fig. 1 zeigt das Ergebnis bei einem üblichen Verdampfer (VV). Kurve 1 zeigt die Meßkurve des Widerstandsverlaufs für den unmittelbar erhitzten Verdampfer. Es ist der typische Widerstandsanstieg für ungeschädigtes Material ersichtlich. Der sich für die gewählte Leistung von 4 kW (Kurve 3) einstellende Hochtemperturwiderstand beträgt ca. 2800 moc (µ Ohm cm). Kurve 2 zeigt zeigt die Meßkurve des Widerstandsverlaufs für das Material nach vorausgegangener 12 stündiger Auslagerung in einem Exsikkator unter 100% Luftfeuchtigkeit bei 20°C. Es ist deutlich zu erkennen, daß im Verlauf der Leistungerhöhung der Widerstand stark ansteigt und Werte > 10.000 moc erreicht. Ein solcher Verdampfer versagt in einer herkömmlichen Bandbedampfungsanlage und muß ausgetauscht werden.

Fig. 2 zeigt das Ergebnis mit den erfindungsgemäßen Verdampfern (EV)
Kurve 1 zeigt die Meßkurve des Widerstandsverlaufs für den unmittelbar erhitzten Verdampfer. Es ist der typische Widerstandsanstieg für ungeschädigtes Material ersichtlich. Der sich für die gewählte Leistung von 4 kW (Kurve 3) einstellende Hochtemperturwiderstand beträgt ca. 4200 moc (µ Ohm cm).
Kurve 2 zeigt die Meßkurve des Widerstandsverlaufs für das Material nach vorausgegangener 12 stündiger Auslagerung in einem Exsikkator unter 100% Luftfeuchtigkeit bei 20°C. Es ist deutlich zu erkennen, das nach Auslagerung keine Schädigung wie in Fig. 1 vorliegt.

Weitere Versuche (Ergebnisse nicht dargestellt) haben gezeigt, daß auch eine Verlängerung der Auslagerungszeit auf mehrere Tage zu keiner Schädigung führt. Der beschriebene Effekt wird auch mit geringeren Additivgehalten von 0,3 - 0,5% erzielt.

Beispiele für Verdampfermaterial mit ≤ 0,5% AlN. Die Verdampfer EV 2 bis EV 6 wurden analog Beispiel 1 hergestellt.

| Sinterkörper | AlN Gehalt [Gew.%] | TiB₂ Gehalt [Gew.%] | BN Gehalt [Gew.%] | CaO Gehalt [Gew.%] | Hochtemp. Widerstand vor Auslagerung [moc ] | Hochtemp. Widerstand nach Auslagerung [moc ] |
|---|---|---|---|---|---|---|
| EV 2 | 0,4 | 47,7 | 50,9 | 1,0 | 2725 | 2730 |
| EV 3 | 0,3 | 48,7 | 50,0 | 1,0 | 2470 | 2480 |
| EV 4 | 0,4 | 47,2 | 51,4 | 1,0 | 2830 | 2840 |
| EV 5 | 0,5 | 46,4 | 52,1 | 1,0 | 3380 | 3300 |

### Beispiel 2

Abdampfrate und Lebensdauer eines erfindungsgemäßen Verdampfers im Vergleich zu bekannten Verdampfern

Ein erfindungsgemäßer Verdampfer (EV1) sowie ein käuflich erhältlicher 3-Komponentenverdampfer (3K-VV) gleicher Dimensionierung (käuflich erhältlich unter der Bezeichnung ESK-Trimet® bei ESK, Kempten) und der 2-Komponentenverdampfer gemäß Beispiel 1 (2K-VV) wurden in der Versuchsmetallisierungsanlage unter üblichen Bedingungen (P < 10⁻³ mbar; Stirnseiteneinspannung) mit der in Tabelle 1 genannten Leistung betrieben. Die gemessene Abdampfrate sowie Lebensdauer sind in Tabelle 1 dargestellt

| | Leistung [KW] | Abdampfrate [g/mincm²] | Lebensdauer [h] |
|---|---|---|---|
| EV | 4 | 0,35 | 10 |
| 2K-VV | 4 | 0,35 | 10 |
| 3K-VV | 3,2 | 0.25 | 9 ← wirtschaftlicher Betrieb |
| | 4 | 0,35 | 6 |
| | 2,4 | 0,2 | 10 |

## Patentansprüche

1. Keramisches Material enthaltend 45 bis 55 Gew.% TiB₂ und 40,5 bis 54,7 Gew.% BN und 0,1 - 1,5 Gew.% Ca in Form einer Verbindung ausgewählt aus der Gruppe der Calciumoxide und der Calciumborate und ihrer Gemische, **dadurch gekennzeichnet, daß** es 0,2 bis 3 Gew.% einer Verbindung ausgewählt aus der Gruppe der Oxide, Carbide und Nitride der Elemente Al, Si, Zr, Ti und ihrer Gemische enthält.

2. Keramisches Material gemäß Anspruch 1, **dadurch gekennzeichnet, daß** es 0,2 bis 1,5 Gew.% einer Verbindung ausgewählt aus der Gruppe der Oxide, Carbide und Nitride der Elemente Al, Si, Zr, Ti und ihrer Gemische enthält.

3. Material gemäß Anspruch 1, **dadurch gekennzeichnet, daß** es 0,2 bis 0,5 Gew.% einer Verbindung ausgewählt aus der Gruppe der Oxide, Carbide und Nitride der Elemente Al, Si, Zr, Ti und ihrer Gemische enthält.

4. Material gemäß einem der Ansprüche 1 bis 3, **dadurch gekennzeichnet, daß** die Verbindung aus der Gruppe der Oxide, Carbide und Nitride der Elemente Al, Si, Zr, Ti und ihrer Gemische ausgewählt ist aus der Gruppe der Nitride der Elemente Al, Si, Zr, Ti und ihrer Gemische.

5. Material gemäß Anspruch 4, **dadurch gekennzeichnet, daß** die Verbindung aus der Gruppe der Nitride der Elemente Al, Si, Zr, Ti und ihrer Gemische AlN ist.

6. Material gemäß einem der Ansprüche 1 bis 5, **dadurch gekennzeichnet, daß** es aus den genannten Komponenten besteht.

7. Verfahren zur Herstellung des Material gemäß einem der Ansprüche 1 bis 6, **dadurch gekennzeichnet, daß** in eine für 2-Komponentenverdampfer übliche TiB₂/BN/CaO-Mischung eine Verbindung ausgewählt aus der Gruppe der Oxide, Carbide und Nitride der Elemente Al, Si, Zr, Ti und ihrer Gemische in feinverteilter Form eingebracht wird und die homogene Pulvermischung Heißpressen in einer Graphitform unter Anwendung von Stempeldruck, bei Temperaturen von mindestens 1800°C unterzogen wird.

8. Verfahren gemäß Anspruch 7, **dadurch gekennzeichnet, daß** die Verbindung ausgewählt aus der Gruppe der Oxide, Carbide und Nitride der Elemente Al, Si, Zr, Ti und ihrer Gemische als Pulver einer mittleren Teilchengröße von 5 bis 15 µm eingesetzt wird.

9. Verdampfer, **dadurch gekennzeichnet, daß** es aus Material gemäß einem der Ansprüche 1 bis 6 besteht.

## Claims

1. Ceramic material containing 45 to 55% by weight TiB₂ and 40.5 to 54.7% by weight BN and 0.1 - 1.5% by weight Ca in the form of a compound selected from the group consisting of the calcium oxides and calcium borates and mixtures thereof, charaterized in that it contains from 0.2 to 3% by weight of a compound selected from the group consisting of the oxides, carbides and nitrides of the elements Al, Si, Zr, Ti and mixtures thereof.

2. Ceramic material according to Claim 1, **characterized in that** it contains from 0.2 to 1.5% by weight of a compound selected from the group consisting of the oxides, carbides and nitrides of the elements Al, Si, Zr, Ti and mixtures thereof.

3. Material according to Claim 1, **characterized in that** it contains from 0.2 to 0.5% by weight of a compound selected from the group consisting of the oxides, carbides and nitrides of the elements Al, Si, Zr, Ti and mixtures thereof.

4. Material according to one of Claims 1 to 3, **characterized in that** the compound selected from the group consisting of the oxides, carbides and nitrides of the elements Al, Si, Zr, Ti and mixtures thereof is selected from the group consisting of the nitrides of the elements Al, Si, Zr, Ti and mixtures thereof.

5. Material according to Claim 4, **characterized in that** the compound selected from the group consisting of the nitrides of the elements Al, Si, Zr, Ti and mixtures thereof is AlN.

6. Material according to one of Claims 1 to 5, **characterized in that** it consists of the abovementioned components.

7. Process for producing the material according to one of Claims 1 to 6, **characterized in that** a compound selected from the group consisting of the oxides, carbides and nitrides of the elements Al, Si, Zr, Ti and mixtures thereof is introduced in finely distributed form into a TiB₂/BN/CaO mixture which is conventional for 2-component vaporizers, and the homogenous powder mixture undergoes hot-pressing in a graphite mould using ram pressure, at temperatures of at least 1800°C.

8. Process according to Claim 7, **characterized in that** the compound selected from. the group consisting of the oxides, carbides and nitrides of the. elements Al, Si, Zr, Ti and mixtures thereof is used as a powder with a mean particle size of from 5 to 15 µm.

9. Vaporizer **charaterized in that** it consists of material according to one of Claims 1 to 6.

## Revendications

1. Matériau céramique comprenant de 45 à 55 % en poids de TiB₂ et de 40,5 à 54,7 % en poids de BN et de 0,1 à 1,5 % en poids de Ca sous forme d'un composé choisi parmi le groupe constitué des oxydes de calcium et des borates de calcium et de leurs mélanges, **caractérisé en ce qu'**il comprend de 0,2 à 3 % en poids d'un composé choisi parmi le groupe constitué des oxydes, des carbures et des nitrures des éléments Al, Si, Zr, Ti et de leurs mélanges.

2. Matériau céramique selon la revendication 1, **caractérisé en ce qu'**il comprend de 0,2 à 1,5 % en poids d'un composé choisi parmi le groupe constitué des oxydes, des carbures et des nitrures des éléments Al, Si, Zr, Ti et de leurs mélanges.

3. Matériau selon la revendication 1, **caractérisé en ce qu'**il comprend de 0,2 à 0,5 % en poids d'un composé choisi parmi le groupe constitué des oxydes, des carbures et des nitrures des éléments Al, Si, Zr, Ti et de leurs mélanges.

4. Matériau selon l'une quelconque des revendications 1 à 3, **caractérisé en ce que** le composé choisi parmi le groupe constitué des oxydes, des carbures et des nitrures des éléments Al, Si, Zr, Ti et de leurs mélanges est choisi parmi le groupe constitué des nitrures des éléments Al, Si, Zr, Ti et de leurs mélanges.

5. Matériau selon la revendication 4, **caractérisé en ce que** le composé est choisi parmi le groupe des nitrures des éléments Al, Si, Zr, Ti et de leurs mélanges AlN.

6. Matériau selon l'une quelconque des revendications 1 à 5, **caractérisé en ce qu'**il est constitué des composants mentionnés.

7. Procédé de préparation du matériau selon l'une quelconque des revendications 1 à 6, **caractérisé en ce qu'**un composé choisi parmi le groupe constitué des oxydes, des carbures et des nitrures des éléments Al, Si, Zr, Ti et de leurs mélanges est introduit sous forme finement divisée dans un mélange de TiB₂/BN/CaO habituel pour des vaporisateurs bicomposants, et le mélange pulvérulent homogène est soumis à un pressage à chaud dans un moule en graphite en employant la pression d'un piston, à des températures d'au moins 1 800°C.

8. Procédé selon la revendication 7, **caractérisé en ce que** le composé choisi parmi le groupe constitué des oxydes, des carbures et des nitrures des éléments Al, Si, Zr, Ti et de leurs mélanges est utilisé sous forme d'une poudre d'une granulométrie moyenne de 5 à 15 µm.

9. Vaporisateur, **caractérisé en ce qu'**il est constitué d'un matériau selon l'une quelconque des revendications 1 à 6.
